# EUROPÄISCHE PATENTSCHRIFT

(11) **EP 2 312 429 B1**
(45) Veröffentlichungstag und Bekanntmachung des Hinweises auf die Patenterteilung: **29.05.2019**
(21) Anmeldenummer: 10186726.5
(22) Anmeldetag: 06.10.2010
(51) Int. Cl.: G06F 3/0481, G06F 3/0488

(54) **Verfahren zum Bereitstellen einer Benutzerschnittstelle und Bedienvorrichtung**
Operating device and method for producing a user interface
Procédé de préparation d'une interface utilisateur et dispositif de commande

(30) Priorität: 09.10.2009 DE 102009048823
(43) Veröffentlichungstag der Anmeldung: 20.04.2011
(73) Patentinhaber: Volkswagen Aktiengesellschaft, 38440 Wolfsburg (DE)
(72) Erfinder: Henze, Stefan, 38104 Braunschweig (DE); Bendewald, Lennart, 38442 Wolfsburg (DE); Wäller, Christoph, 38106 Braunschweig (DE)
(74) Vertreter: Reitstötter Kinzebach

(56) Entgegenhaltungen:
- WO-A2-2007/041284
- DE-A1-102005 048 230
- US-A- 5 850 212
- US-A1- 2004 246 240
- US-A1- 2006 062 382

## Beschreibung

Die vorliegende Erfindung betrifft ein Verfahren zum Bereitstellen einer Benutzerschnittstelle, bei dem auf die Betätigung eines Bedienelements für ein erstes Zeitintervall ein erstes Eingabesignal erzeugt wird, wobei das erste Zeitintervall in einem ersten Zeitbereich liegt, der bei einer initialen Betätigung zu einem ersten Zeitpunkt beginnt und zu einem zweiten Zeitpunkt endet. Auf die Betätigung des Bedienelements für ein zweites Zeitintervall wird ein zweites Eingabesignal erzeugt, wobei das zweite Zeitintervall von der initialen Betätigung zu dem ersten Zeitpunkt bis zu einem dritten Zeitpunkt dauert, wobei die Betätigung innerhalb eines zweiten Zeitbereichs beendet wird, wobei sich die beiden Zeitbereiche nicht überschneiden. Dabei wird nach der initialen Betätigung des Bedienelements eine Mitteilung dafür ausgegeben, dass in Abhängigkeit von der Dauer der Betätigung des Bedienelements unterschiedliche Eingabesignale erzeugt werden. Dabei wird ferner zur Betätigung des Bedienelements eine Schaltfläche auf einer Anzeigefläche angezeigt.

Des Weiteren betrifft die Erfindung eine Bedienvorrichtung mit zumindest einem Bedienelement und einer mit dem Bedienelement gekoppelten Steuervorrichtung, mit welcher ein erstes Eingabesignal erzeugbar ist, wenn das Bedienelement für ein erstes Zeitintervall betätigt worden ist, wobei das erste Zeitintervall in einem ersten Zeitbereich liegt, der bei einer initialen Betätigung zu einem ersten Zeitpunkt beginnt und zu einem zweiten Zeitpunkt endet. Ein zweites Eingabesignal ist erzeugbar, wenn das Bedienelement für ein zweites Zeitintervall betätigt worden ist, wobei das zweite Zeitintervall von der initialen Betätigung zu dem ersten Zeitpunkt bis zu einem dritten Zeitpunkt dauert, wobei die Betätigung innerhalb eines zweiten Zeitbereichs beendet wird, wobei sich die beiden Zeitbereiche nicht überschneiden. Dabei ist eine Ausgabevorrichtung vorgesehen, mittels welcher nach der initialen Betätigung des Bedienelements eine Mitteilung dafür ausgebbar ist, dass in Abhängigkeit von der Dauer der Betätigung des Bedienelements unterschiedliche Eingabesignale erzeugt werden. Dabei ferner ist zur Betätigung des Bedienelements eine Schaltfläche auf einer Anzeigefläche anzeigbar.

Die Bedienvorrichtung ist insbesondere Teil eines Fahrzeugs. Sie kann jedoch auch in Verbindung mit anderen Geräten, insbesondere tragbaren Geräten, wie einem Musikspieler, einem Mobiltelephon oder einem mobilen Navigationssystem eingesetzt werden.

In einem Fahrzeug sind herkömmlicherweise verschiedene Bedienelemente angeordnet, um Einrichtungen des Fahrzeugs zu steuern. Beispielsweise können mechanische Tastschalter vorgesehen sein, um eine Scheibenheizung oder eine Klimaanlage an- und auszuschalten. Ferner können mechanische Drehschalter vorgesehen sein, um z. B. die Temperatur im Innenraum des Fahrzeugs und die Stärke des Gebläses der Lüftung einzustellen. Des Weiteren können im Fahrzeug eine Vielzahl weiterer Bedienelemente für ein Navigationssystem, für Fahrerassistenzsysteme sowie für Kommunikations- und Multimediaanwendungen vorgesehen sein.

Aufgrund der Zunahme elektronischer Einrichtungen im Fahrzeug ist es nicht mehr möglich, für alle Einrichtungen separate mechanische Bedienelemente vorzusehen. Deshalb werden in Fahrzeugen vielfach Multifunktionsbediensysteme eingesetzt, um die Einrichtungen mittels weniger Bedienelemente zu steuern. Derartige Multifunktionsbediensysteme umfassen üblicherweise eine Multifunktionsanzeige sowie eine zentrale Eingabevorrichtung. Die zentrale Eingabevorrichtung kann beispielsweise einen Drehdrückschalter umfassen, mit welchem Schaltflächen, die mittels der Anzeigevorrichtung angezeigt werden, betätigt werden können.

Des Weiteren wurde vorgeschlagen, die Anzeigefläche selbst mit einer berührungsempfindlichen Oberfläche auszustatten und auf diese Weise einen so genannten Touchscreen zur Verfügung zu stellen. Bei einem solchen Touchscreen erfolgt die Bedienung dadurch, dass der Nutzer mit einem Betätigungselement, wie beispielsweise einem Stift oder der Fingerspitze eines Nutzers, den Touchscreen berührt. Die Position der Berührung wird erfasst, ausgewertet und einem Bedienvorgang zugeordnet. Eine Anzeigevorrichtung mit einer berührungsempfindlichen Oberfläche, die in Verbindung mit einem Navigationssystem eingesetzt wird, ist beispielsweise in der DE 10 2005 020 155 A1 beschrieben.

Wenn ein Touchscreen als Eingabevorrichtung verwendet wird, ist es bekannt, auf der Anzeigefläche Schaltflächen anzuzeigen, die durch eine Berührung mit einem Betätigungselement betätigt werden können. Durch derartige Schaltflächen können mechanische Schalter ersetzt werden. Es ist des Weiteren bekannt, derartige Schaltflächen so auszugestalten, dass verschiedene Eingabesignale in Abhängigkeit davon erzeugt werden, wie lange die Schaltfläche berührt wird. Beispielsweise kann bei einem kurzen Antippen der Schaltfläche ein anderes Eingangssignal erzeugt werden als bei einer längeren Berührung der Schaltfläche (einem sogenannten Longpress). Die Möglichkeit, durch ein langes Berührung der Schaltfläche ein anderes Eingangssignal zu erzeugen als bei einem kurzen Antippen der Schaltfläche, muss dem Nutzer jedoch vermittelt werden. Aus diesem Grund ergibt sich häufig das Problem, dass der Nutzer nicht weiß, dass er durch ein längeres Berühren der Schaltfläche ein anderes Eingabesignal erzeugt. Dies kann entweder dazu führen, dass der Nutzer von der Möglichkeit, ein weiteres Eingabesignal zu erzeugen, keinen Gebrauch macht oder unbeabsichtigt ein falsches Eingabesignal erzeugt.

Für eine Benutzerschnittstelle und eine Bedienvorrichtung, die in einem Fahrzeug untergebracht sind, ergeben sich sehr spezielle Anforderungen. Die für die Bedienung erforderliche Informationsaufnahme erfolgt im Fahrzeug unter anderem durch den Fahrer. Die Information sollte somit im Fahrzeug so dargestellt werden, dass die Informationsaufnahme durch den Fahrer nicht zu einer Ablenkung während der Fahrt führt. Die dargestellten Informationen sollten daher intuitiv und schnell vom Fahrer erfassbar sein, so dass dieser für die Informationsaufnahme nur sehr kurzzeitig den Blick vom Fahrgeschehen abwenden muss. Des Weiteren sollte der durch den Nutzer ausgeführte Betätigungsvorgang so schnell wie möglich ausführbar sein.

Auch bei einer Benutzerschnittstelle und einer Bedienvorrichtung, die in Verbindung mit mobilen Geräten eingesetzt werden, sollte die Bedienung so einfach, schnell und intuitiv wie möglich sein. Die in Verbindung mit der Bedienung angezeigten Informationen sollten außerdem schnell und intuitiv erfasst werden können. Der Nutzer des mobilen Geräts nimmt nämlich die angezeigten Informationen häufig auf, während er andere Tätigkeiten ausführt. Auch die Bedienung dieser Geräte erfolgt vielfach in solchen Situationen. Dabei ergibt sich zusätzlich das Problem, dass die Anzeigefläche und die Bedienelemente eines mobilen Geräts vielfach relativ klein sind, so dass es besonders wichtig ist, dass die dargestellten Informationen leicht erfassbar und die Bedienung mit möglichst wenigen Betätigungsvorgängen ausführbar ist.

Die WO 2007/041284 A2 betrifft ein Verfahren und ein System zum Steuern diverser Einrichtungen mittels einer elektronischen Programmführung. Dabei können über ein Bedienelement drei verschiedene Funktionen ausgelöst werden, indem das Bedienelement eine vorgegebene Zeitspanne lang vor oder nach Ablauf von zwei unterschiedlichen Timern betätigt wird. Um dem Nutzer den Ablauf der Zeit und die jeweils dazugehörigen Funktionen zu visualisieren, kann der Ablauf der Timer am Bedienelement angezeigt werden, zum Beispiel in Form sich füllender, konzentrischer Kreise. Die auszulösenden Funktionen sind den einzelnen Timern fest zugeordnet, so dass vor Ablauf des ersten Timers ein Steuersignal zum Wechseln des Geräts erzeugt wird, nach Ablauf des ersten Timers, aber noch vor Ablauf des zweiten Timers ein Steuersignal zum Anzeigen einer Schnellansicht erzeugt wird und nach Ablauf dieses zweiten Timers ein Steuerbefehl zum Anzeigen einer Programmführung erzeugt wird.

Die US 2004/246240 A1 beschreibt ein Verfahren zum Erkennen einer Nutzereingabe, insbesondere von Handschrifteingaben. Dabei wird ein sogenanntes "Pen-Down"-Ereignis und eine nachfolgende "Press-and-hold"-Geste erfasst, woraufhin eine Bewegungs- oder Stricherfassung erfolgt, z.B. durch Messen der durchlaufenen Koordinaten auf dem Bildschirm. Um eine solche Bewegungserfassung sicher zu erkennen, wird eine gewisse Verzögerung zwischen dem "Pen-Down"-Ereignis und der "Press-and-hold"-Geste festgelegt, die dann entsprechend visualisiert werden kann.

Aus der US 5 850 212 A ist ein System bekannt, bei dem mittels eines einzelnen Druccknopfes zwischen verschiedenen Erscheinungsformen und Modi eines Cursors umgeschaltet wird. Dabei kann sich die Richtung eines dargestellten Pfeils verändern, wenn kurz gedrückt wird, und eine Verschiebung des Cursors vorgenommen werden, wenn lange gedrückt wird.

In der DE 10 2005 048230 A1 wird eine Eingabevorrichtung beschrieben, bei der in Abhängigkeit von der Dauer einer Berührung eines Touchscreens zwei Funktionen aufgerufen werden können. So kann durch langes Drücken auf einen Buchstaben einer Tastatur ein Menü zur Auswahl zugeordneter Zeichen aufgerufen werden.

Die US 2006/0062382 A1 schließlich beschreibt ein Verfahren, durch das ein Nutzer über eine Zusatzfunktion informiert wird, die durch ein langes Betätigen eines Schalters aufgerufen werden kann. Dabei wird beschrieben, dass während des Drückens des Schalters ein Symbol eingeblendet wird, um anzuzeigen, welche Funktion beim Überschreiten einer bestimmten Zeitdauer verfügbar sein wird.

Der vorliegenden Erfindung liegt die Aufgabe zugrunde, ein Verfahren zum Bereitstellen einer Benutzerschnittstelle und eine Bedienvorrichtung der eingangs genannten Art bereitzustellen, mit denen Eingaben so einfach und intuitiv wie möglich getätigt werden können.

Diese Aufgabe wird erfindungsgemäß durch ein Verfahren mit den Merkmalen des Anspruchs 1 und eine Bedienvorrichtung mit den Merkmalen des Anspruchs 5 gelöst. Vorteilhafte Aus- und Weiterbildungen ergeben sich aus den abhängigen Ansprüchen.

Das erfindungsgemäße Verfahren ist dadurch gekennzeichnet, dass in Folge der initialen Betätigung die Schaltfläche in einen inneren Anzeigebereich und einen ringförmigen äußeren Anzeigebereich unterteilt wird und die Mitteilung dadurch erfolgt, dass sich der äußere Anzeigebereich zeitlich so verändert, dass die Länge des ersten und/oder des zweiten Zeitintervalls visualisiert wird. Dabei vergrößert sich ein hervorgehoben dargestellter Teil des äußeren Anzeigebereichs bis zum Ablauf des ersten Zeitbereichs und verkleinert sich ab dem Beginn des zweiten Zeitbereichs wieder. Dabei werden bei der Vergrößerung des hervorgehoben dargestellten Teils zwei Balken so lange wachsend dargestellt, bis der Ring des äußeren Anzeigebereichs geschlossen ist.

Bei dem erfindungsgemäßen Verfahren wird insbesondere vor dem Start des Betätigungsvorgangs des Bedienelements kein Hinweis dafür ausgegeben, dass in Abhängigkeit von der Dauer der Betätigung des Bedienelements unterschiedliche Eingabesignale erzeugt werden. Dies führt zu einer Reduktion der Informationen, die der Nutzer aufnimmt. Will der Nutzer nämlich das Bedienelement überhaupt nicht betätigen, benötigt er zunächst auch nicht die Information, dass bei der Betätigung des Bedienelements verschiedene Eingabesignale erzeugt werden können. Nachdem die Betätigung des Bedienelements jedoch begonnen wurde, erfährt der Nutzer durch die ausgegebene Mitteilung, dass er durch die begonnene Betätigung des Bedienelements verschiedene Eingabesignale erzeugen kann.

Durch die bei dem erfindungsgemäßen Verfahren vorgesehene Möglichkeit, durch die Betätigung des Bedienelements in Abhängigkeit von der Dauer der Betätigung verschiedener Eingabesignale zu erzeugen, wird die Eingabe mittels der Benutzerschnittstelle vereinfacht und beschleunigt, da zum Erzeugen der beiden Eingabesignale nicht separate Bedienelemente vorgesehen werden müssen oder dem Bedienelement nicht durch einen weiteren Betätigungsvorgang erst eine andere Funktion zugewiesen werden muss.

Erfindungsgemäß beginnen sowohl das erste als auch das zweite Zeitintervall bei der initialen Betätigung des Bedienelements. Das zweite Zeitintervall endet jedoch später als das erste Zeitintervall. Ferner kann die Dauer des ersten Zeitintervalls in einem ersten Zeitbereich und die Dauer des zweiten Zeitintervalls in einem zweiten Zeitbereich liegen, wobei sich die beiden Zeitbereiche nicht überschneiden. Die beiden Zeitbereiche schließen insbesondere aneinander an. Der erste Zeitbereich dauert dann von der initialen Betätigung des Bedienelements bis zu einem ersten Zeitpunkt und der zweite Zeitbereich dauert von dem ersten Zeitpunkt bis zu einem zweiten Zeitpunkt.

Gemäß einer Ausgestaltung des erfindungsgemäßen Verfahrens wird das zweite Eingabesignal unmittelbar nach Ablauf des ersten Zeitintervalls erzeugt.

Gemäß der Erfindung wird die Mitteilung graphisch ausgegeben. Zur Betätigung des Bedienelements wird eine Schaltfläche auf einer Anzeigefläche angezeigt. Unter einer *Schaltfläche* wird im Sinne der Erfindung ein Steuerelement einer graphischen Benutzerschnittstelle verstanden. Eine Schaltfläche unterscheidet sich von Elementen und Flächen zur reinen Informationsanzeige, so genannten Anzeigeelementen bzw. Anzeigenflächen, darin, dass sie auswählbar sind. Bei einer Auswahl einer Schaltfläche wird eine ihr zugeordnete Funktion ausgeführt. Die Funktion kann nur zu einer Veränderung der Informationsanzeige führen. Ferner können über die Schaltflächen auch Einrichtungen gesteuert werden, deren Bedienung von der Informationsanzeige unterstützt wird. Die Schaltflächen können somit herkömmliche mechanische Schalter ersetzen. Die Schaltflächen können beliebig auf einer frei programmierbaren Anzeigefläche erzeugt und angezeigt werden. Des Weiteren kann vorgesehen sein, dass eine Schaltfläche markiert werden kann. In diesem Fall wird die zugeordnete Funktion noch nicht ausgeführt. Die markierte Schaltfläche wird jedoch gegenüber anderen Schaltflächen hervorgehoben dargestellt. Die Markierung und/oder Auswahl einer Schaltfläche kann mittels einer Cursorsteuerung oder durch direkte Bedienung einer berührungsempfindlichen Anzeigefläche erfolgen.

Die Mitteilung erfolgt dadurch, dass sich ein Anzeigebereich zeitlich so verändert, dass die Dauer des ersten und/oder zweiten Zeitintervalls visualisiert wird. Der Anzeigebereich ist insbesondere innerhalb der Schaltfläche oder benachbart zu der Schaltfläche gebildet. Ein hervorgehoben dargestellter Teil des Anzeigebereichs vergrößert sich bis zum Ablauf des ersten Zeitintervalls und verkleinert sich ab dem Beginn des zweiten Zeitintervalls wieder. Der Anzeigebereich kann insbesondere eine eindimensionale Linien- oder Balkendarstellung sein, die sukzessive hervorgehoben dargestellt wird, bis der erste Zeitbereich abgelaufen ist, und danach sukzessive wieder verschwindet, bis der zweite Zeitbereich abgelaufen ist. Anhand des hervorgehoben dargestellten Teils des Anzeigebereichs kann der Betrachter sehr intuitiv und schnell erfassen, ob das erste oder das zweite Eingabesignal erzeugt wird, wenn er den Betätigungsvorgang beendet. Außerdem kann der Betrachter leicht erfassen, wie viel Zeit er noch zum Erzeugen des ersten bzw. zweiten Eingabesignals hat.

Gemäß einer weiteren Ausgestaltung des erfindungsgemäßen Verfahrens kann während des zweiten Zeitbereichs zusätzlich oder alternativ ein Hinweis auf den Inhalt des zweiten Eingabesignals angezeigt werden.

Gemäß einer weiteren Ausgestaltung des erfindungsgemäßen Verfahrens kann die Mitteilung zusätzlich oder alternativ akustisch ausgegeben werden. In diesem Fall kann beispielsweise nach der Betätigung des Bedienelements ein akustisches Signal ausgegeben werden. Das akustische Signal kann entweder unmittelbar nach der initialen Betätigung des Bedienelements ausgegeben werden oder erst nach Ablauf des ersten Zeitbereichs. Die Mitteilung kann in diesem Fall dadurch erfolgen, dass sich das akustische Signal zeitlich so verändert, dass die Länge des ersten und/oder zweiten Zeitintervalls akustisch mitgeteilt wird. Dabei kann beispielsweise die zeitliche Struktur des Signals verändert werden. Ferner kann die Amplitude und/oder die Frequenz des akustischen Signals verändert werden. Außerdem kann während des zweiten Zeitbereichs ein Hinweis auf den Inhalt des zweiten Eingabesignals mittels des akustischen Signals ausgegeben werden.

Gemäß einer weiteren Ausgestaltung des erfindungsgemäßen Verfahrens wird die Mitteilung alternativ oder zusätzlich haptisch ausgegeben. Beispielsweise kann nach der Betätigung des Bedienelements das Bedienelement zur haptischen Ausgabe der Mitteilung in Schwingung versetzt werden. Die haptische Ausgabe kann entweder unmittelbar nach der initialen Betätigung des Bedienelements erfolgen oder erst nach Ablauf des ersten Zeitbereichs.

Bei dem erfindungsgemäßen Verfahren kann dem Nutzer somit auf graphische, akustische und/oder haptische Weise mitgeteilt werden, dass in Abhängigkeit von der Dauer der Betätigung des Bedienelements unterschiedliche Eingabesignale erzeugt werden.

Bei dem zweiten Eingabesignal handelt es sich insbesondere um ein Aktivierungssignal für eine Spracheingabe. Dadurch wird erreicht, dass z. B. nach Ablauf des ersten Zeitintervalls Spracheingaben erfasst werden.

Die erfindungsgemäße Bedienvorrichtung ist dadurch gekennzeichnet, dass in Folge der initialen Betätigung die Schaltfläche in einen inneren Anzeigebereich und einen ringförmigen äußeren Anzeigebereich unterteilbar ist und die Mitteilung dadurch erfolgt, dass der äußere Anzeigebereich zeitlich so veränderbar ist, dass die Länge des ersten und/oder des zweiten Zeitintervalls visualisiert wird. Dabei vergrößert sich ein hervorgehoben dargestellter Teil des äußeren Anzeigebereichs bis zum Ablauf des ersten Zeitbereichs und verkleinert sich ab dem Beginn des zweiten Zeitbereichs wieder. Dabei sind bei der Vergrößerung des hervorgehoben dargestellten Teils zwei Balken so lange wachsend darstellbar, bis der Ring des äußeren Anzeigebereichs geschlossen ist.

Die erfindungsgemäße Bedienvorrichtung ist insbesondere so ausgebildet, dass sie die Schritte des vorstehend beschriebenen Verfahrens teilweise oder vollständig ausführen kann. Sie stellt somit auch dieselben Vorteile bereit wie das vorstehend beschriebene Verfahren.

Gemäß einer Ausgestaltung der erfindungsgemäßen Bedienvorrichtung umfasst die Ausgabevorrichtung eine Anzeigevorrichtung, mit welcher die Mitteilung graphisch ausgebbar ist. Auf der Anzeigevorrichtung ist insbesondere eine berührungsempfindliche Oberfläche ausgebildet. Es wird somit ein sogenannter Touchscreen bereitgestellt. Das Bedienelement kann in diesem Fall eine von der Anzeigevorrichtung angezeigte Schaltfläche sein.

Gemäß einer weiteren Ausgestaltung der erfindungsgemäßen Bedienvorrichtung umfasst die Ausgabevorrichtung einen Lautsprecher, mit welchem die Mitteilung akustisch ausgebbar ist. Des Weiteren kann die Ausgabevorrichtung eine haptische Ausgabeeinheit umfassen. Mittels der haptischen Ausgabeeinheit ist beispielsweise das Bedienelement in Schwingung versetzbar. Falls die Betätigung des Bedienelements von einer Anzeigevorrichtung mit einer berührungsempfindlichen Oberfläche bereitgestellt wird, kann die haptische Ausgabeeinheit beispielsweise die Anzeigevorrichtung in Schwingung versetzen.

Das erfindungsgemäße Verfahren wird insbesondere in einem Fahrzeug eingesetzt. Die erfindungsgemäße Bedienvorrichtung ist insbesondere in einem Fahrzeug untergebracht, um eine Benutzerschnittstelle zu den verschiedenen Einrichtungen des Fahrzeugs bereitzustellen. Des Weiteren kann das erfindungsgemäße Verfahren sowie die erfindungsgemäße Bedienvorrichtung jedoch auch in einem anderen Gerät, insbesondere in einem mobilen Gerät, eingesetzt werden.

Die Erfindung wird nun anhand eines Ausführungsbeispiels mit Bezug zu den Zeichnungen erläutert.
- Figur 1: zeigt schematisch ein Ausführungsbeispiel der erfindungsgemäßen Bedienvorrichtung und die Verbindung dieser Bedienvorrichtung mit anderen Einrichtungen,
- Figur 2: zeigt einen Zeitstrahl, durch welchen die verschiedenen Zeitintervalle und Zeitbereiche veranschaulicht werden sollen und
- die Figuren 3 bis 6: zeigen Anzeigen auf der Anzeigefläche, die von einem Ausführungsbeispiel des erfindungsgemäßen Verfahrens erzeugt werden.

Das im Folgenden beschriebene Ausführungsbeispiel betrifft den Einsatz der Bedienvorrichtung und des Verfahrens in einem Fahrzeug, insbesondere einem Kraftfahrzeug. Mittels Bedienvorrichtung und durch das Verfahren können den Fahrzeuginsassen Informationen angezeigt werden. Ferner können die Fahrzeuginsassen mittels der Bedienvorrichtung Einrichtungen des Fahrzeugs bedienen und die Anzeige steuern. Es wird jedoch darauf hingewiesen, dass die Bedienvorrichtung und das Verfahren auf gleiche Weise auch in anderen Geräten, wie zum Beispiel mobilen Geräten, eingesetzt werden können.

Die Bedienvorrichtung umfasst eine Anzeigevorrichtung 1 mit einer Anzeigefläche 2, die so im Innenraum des Fahrzeugs angeordnet ist, dass sie für zumindest einen Fahrzeuginsassen, insbesondere den Fahrer, gut sichtbar ist. Die Anzeigefläche 2 kann von einem Display, insbesondere einem Flüssigkeitskristalldisplay, beliebiger Bauart bereitgestellt werden.

Die Anzeigevorrichtung 1 ist mit einer Steuervorrichtung 3 verbunden, mit welcher Graphikdaten zur Informationsdarstellung auf der Anzeigefläche 2 erzeugbar sind. Die Steuervorrichtung 3 ist ferner mit einer Eingabevorrichtung 4 verbunden, über welche der Nutzer Einrichtungen des Fahrzeugs, deren Informationen auf der Anzeigefläche 2 angezeigt werden, steuern kann. Ferner kann mittels der Eingabevorrichtung 4 die Informationsanzeige auf der Anzeigefläche 2 gesteuert werden.

In dem vorliegenden Ausführungsbeispiel wird die Eingabevorrichtung 4 durch eine berührungsempfindliche Oberfläche der Anzeigefläche 2 bereitgestellt. Beispielsweise kann eine Folie über der Anzeigefläche 2 angeordnet sein, mit welcher die Position einer Berührung eines Betätigungselements detektiert werden kann. Bei dem Betätigungselement handelt es sich insbesondere um die Fingerspitze eines Nutzers. Die Folie kann z. B. als resistive Touchfolie, kapazitive Touchfolie oder piezoelektrische Folie ausgebildet sein. Ferner kann die Folie so ausgebildet sein, dass ein Wärmestrom, der z. B. von der Fingerspitze eines Nutzers ausgeht, gemessen wird. Aus der zeitlichen Entwicklung der Berührung der Folie lassen sich verschiedene Eingaben gewinnen. Beispielsweise kann im einfachsten Fall das Berühren der Folie bei einer bestimmten Position erfasst und einem auf der Anzeigefläche 2 angezeigten graphischen Objekt 5 zugeordnet werden. Des Weiteren kann die Länge der Berührung bei einer bestimmten Position oder innerhalb eines bestimmten Bereichs erfasst werden.

Statt einer berührungsempfindlichen Oberfläche kann die Eingabevorrichtung 4 auch von einem abgesetzten Bedienelement gebildet werden. In diesem Fall kann die Betätigung dieses Bedienelements von der Anzeige auf der Anzeigefläche 2 unterstützt werden. Im Folgenden wird jedoch davon ausgegangen, dass als Eingabevorrichtung 4 eine berührungsempfindliche Oberfläche vorgesehen ist.

Die Anzeigefläche 2 mit der berührungsempfindlichen Oberfläche, welche von der Fingerspitze des Nutzers berührt wird, ist außerdem in der Ebene der Oberfläche, die in diesem Fall mit der Ebene der Anzeigefläche 2 zusammenfällt, hin und her verschiebbar. Des Weiteren kann die berührungsempfindliche Oberfläche auch in einer zu dieser Ebene senkrechten Richtung hin und her verschiebbar sein. Hierfür ist die Anzeigevorrichtung 1 mit einer haptischen Ausgabeeinheit 8 gekoppelt, welche Aktuatoren umfasst, welche die Anzeigefläche 2 in Schwingung versetzen können, um den Nutzer eine haptische Mitteilung zu übertragen, wenn dieser die berührungsempfindliche Oberfläche der Anzeigevorrichtung 1 berührt. Die Aktuatoren bewirken, dass die Anzeigefläche 2 mit der berührungsempfindlichen Oberfläche relativ zu einer festen Basis der Anzeigevorrichtung 1 bewegt wird. Durch diese Bewegung wird eine Kraft auf die Fingerspitze ausgeübt, welche die berührungsempfindliche Oberfläche berührt. Die Kraft wird vom Nutzer als haptisches Feedback wahrgenommen. Die Aktuatoren können beispielsweise piezoelektrisch betrieben werden. Weitere Details und Möglichkeiten, die berührungsempfindliche Oberfläche hin und her zu bewegen, sind in der US 7,148,875 B2 beschrieben.

Des Weiteren kann die Steuervorrichtung 3 mit einem Lautsprecher 7 verbunden sein, über welchen akustische Mitteilungen in den Innenraum des Fahrzeugs ausgegeben werden können.

Schließlich ist die Steuervorrichtung 3 mit einem Fahrzeugbus 6 gekoppelt, über den sie mit weiteren Einrichtungen des Fahrzeugs verbunden ist, zu denen Informationen auf der Anzeigefläche 2 angezeigt werden sollen und die mittels der Eingabevorrichtung 4 bedient werden sollen.

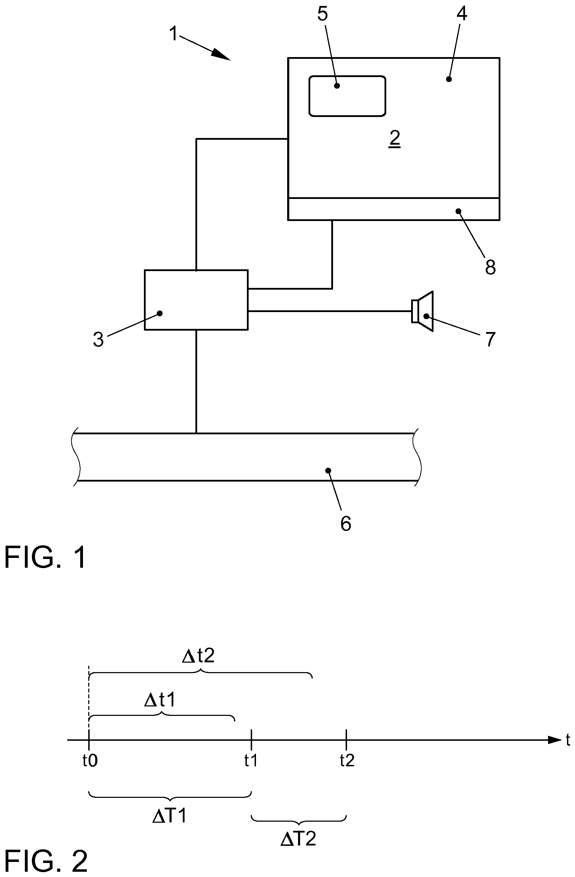

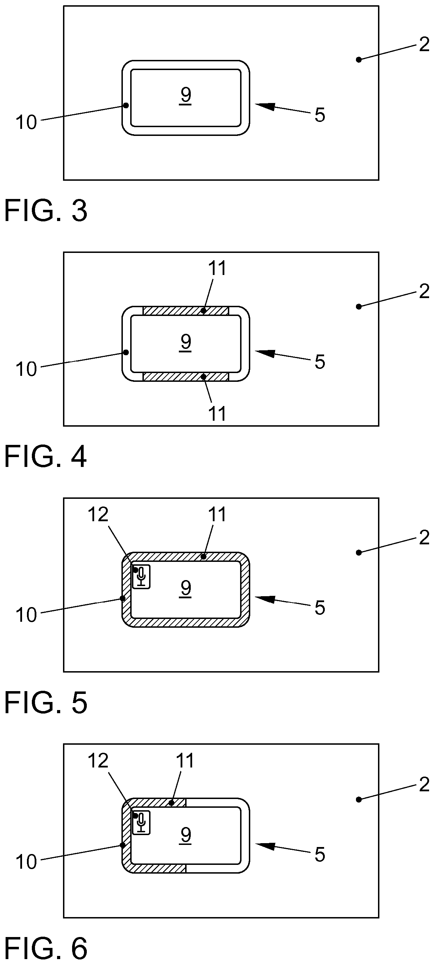

Im Folgenden wird ein Ausführungsbeispiel des erfindungsgemäßen Verfahrens, welches von der vorstehend beschriebenen Bedienvorrichtung ausführbar ist, mit Bezug zu den Figuren 2 bis 6 im Detail erläutert:
Bei dem im Folgenden beschriebenen Verfahren wird als Bedienelement eine Schaltfläche 5 auf der Anzeigefläche 2 dargestellt. Die Schaltfläche 5 kann durch die Berührung der berührungsempfindlichen Oberfläche im Bereich der Schaltfläche 5 betätigt werden. Die Zeitabfolge der Betätigung wird anhand von Figur 2 veranschaulicht:
Der Betätigungsvorgang beginnt mit der initialen Betätigung des Bedienelements, d.h. mit dem Beginn der Berührung der berührungsempfindlichen Oberfläche im Bereich der Schaltfläche 5. Der Zeitpunkt der initialen Betätigung ist auf den Zeitstrahl der Figur 2 mit t0 bezeichnet. Diese initiale Betätigung der Schaltfläche 5 wird von der Steuervorrichtung 3 erfasst. In Folge wird die Schaltfläche 5 wie in Figur 3 gezeigt in einen inneren Anzeigebereich 9 und einen ringförmigen äußeren Anzeigebereich 10 unterteilt. Der Anzeigebereich 10 bildet somit einen Rahmen der Schaltfläche 5. Im Anzeigebereich 9 wird die der Schaltfläche 5 zugeordnete Information dargestellt. Der Anzeigebereich 10 dient dem Nutzer als Mitteilung dafür, dass in Abhängigkeit von der Dauer der Betätigung des Bedienelements, d.h. der Dauer der Berührung der berührungsempfindlichen Oberfläche 4 bei der Schaltfläche 5, unterschiedliche Eingabesignale erzeugt werden. Anhand des Anzeigebereichs 10 wird dem Nutzer vermittelt, welches Eingabesignal erzeugt wird, wenn er beispielsweise seine Fingerspitze von der berührungsempfindlichen Oberfläche löst und damit den Betätigungsvorgang beendet. Ferner wird dem Nutzer anhand des Anzeigebereichs 10 vermittelt, wie lange noch das erste bzw. zweite Eingabesignal erzeugt wird, wenn er den Betätigungsvorgang beendet.

Wie in Figur 2 veranschaulicht dauert das erste Zeitintervall Δt1 von der initialen Betätigung zum Zeitpunkt t0 bis zum Zeitpunkt t1. Die Länge des Zeitintervalls Δt1 liegt in einem Zeitbereich ΔT1. Dieser Zeitbereich ΔT1 beginnt zum Zeitpunkt t0 und endet zum Zeitpunkt t1. Wenn der Nutzer die Berührung von der berührungsempfindlichen Oberfläche 4 innerhalb des Zeitbereichs ΔT1 löst, wird das erste Eingabesignal erzeugt.

Das zweite Zeitintervall Δt2 beginnt wie das erste Zeitintervall Δt1 mit der initialen Betätigung des Bedienelements, d.h. zum Zeitpunkt t0. Es endet jedoch zu einem späteren Zeitpunkt t2. Wenn der Nutzer das Bedienelement für das Zeitintervall Δt2 betätigt, d.h. die Betätigung des Bedienelements vor dem Zeitpunkt t2 beendet, d.h. die Berührung von der berührungsempfindlichen Oberfläche in einen zweiten Zeitbereich ΔT2 löst, wird ein zweites Eingabesignal erzeugt, welches sich von dem ersten Eingabesignal unterscheidet. Der zweite Zeitbereich ΔT2 schließt - wie in Figur 2 gezeigt - unmittelbar an den ersten Zeitbereich ΔT1 an, d.h. er beginnt zum Zeitpunkt t1 und endet beim Zeitpunkt t2. Es wird darauf hingewiesen, dass der zweite Zeitpunkt t2 auch offen gelassen werden kann, d.h. dass nach einer beliebig langen Betätigung des Bedienelements über den Zeitpunkt t1 hinaus das zweite Eingabesignal erzeugt wird.

Bei dem ersten Eingabesignal kann es sich beispielsweise um die Auswahl eines Objekts handeln, welches der Schaltfläche 5 zugeordnet ist. Bei dem zweiten Eingabesignal kann es sich beispielsweise um ein Aktivierungssignal für eine Spracheingabe handeln. Wird nach einer längeren Betätigung der Schaltfläche 5 somit die Spracheingabe aktiviert, kann der Nutzer eine Spracheingabe tätigen, welche einem Objekt zugeordnet wird, welches der Schaltfläche 5 zugeordnet ist. Die Möglichkeit der Spracheingabe kann auch unmittelbar mit dem Beginn des Zeitbereichs ΔT2, d.h. zum Zeitpunkt t1, automatisch beginnen, und enden, wenn der Nutzer die Berührung von der berührungsempfindlichen Oberfläche löst. Die Spracheingaben können in diesem Fall erfolgen, während der Nutzer die berührungsempfindliche Oberfläche berührt.

Im Folgenden wird mit Bezug zu den Figuren 3 bis 6 erläutert, welche Anzeigen auf der Anzeigefläche 2 während der Berührung der Schaltfläche 5 dargestellt werden:
In Figur 3 ist die Ausgangsanzeige gezeigt, die entweder bereits vor der Berührung der Schaltfläche 5 angezeigt wird oder die unmittelbar nach der initialen Berührung der Schaltfläche 5 angezeigt wird. Unmittelbar nach der Berührung der Schaltfläche 5 wird innerhalb dieses Anzeigebereichs 10 ein Teil 11 hervorgehoben dargestellt. Beispielsweise wird Teil 11 in einer bestimmten Farbe oder mit einer bestimmten Helligkeit dargestellt. Der hervorgehoben dargestellte Teil 11 des Anzeigebereichs 10 vergrößert sich wie in Figur 4 gezeigt sukzessive bis zum Zeitpunkt t1 der hervorgehoben dargestellte Teil 11 des Anzeigebereichs 10 diesen vollständig einnimmt. Dem Nutzer wird auf diese Weise vermittelt, dass bis zu diesem Zeitpunkt das erste Eingabesignal erzeugt wird, wenn er die Berührung von der berührungsempfindlichen Oberfläche löst. Wenn der Nutzer die Berührung von der berührungsempfindlichen Oberfläche 4 nach dem Zeitpunkt t1 löst, wird das zweite Eingabesignal erzeugt. Dies wird graphisch durch ein Hinweissymbol 12 innerhalb des inneren Anzeigebereichs 9 der Schaltfläche 5 dargestellt, welches im Zeitbereich ΔT2 eingeblendet wird. Ferner kann der hervorgehoben dargestellte Teil 11 des Anzeigebereichs 10 beispielsweise die Farbe oder die Helligkeit wechseln, um auch auf diese Weise dem Nutzer zu vermitteln, dass bei der Beendigung des Betätigungsvorgangs ein anderes Eingabesignal erzeugt wird.

Vom Zeitpunkt t1 bis zum Zeitpunkt t2 verkleinert sich der hervorgehoben dargestellte Teil 11 des Anzeigebereichs 10 wieder, bis zum Zeitpunkt t2 der hervorgehoben dargestellte Teil 11 verschwunden ist. Die Verringerung des hervorgehoben dargestellten Teils 11 erfolgt jedoch auf andere Weise als die Vergrößerung dieses Teils 11. Bei der Vergrößerung wachsen - wie in Figur 4 gezeigt - zwei Balken so lange, bis der Ring des Anzeigebereichs 10 geschlossen ist. Bei der Verkleinerung des hervorgehoben dargestellten Teils 11 verkleinert sich - wie in Figur 6 gezeigt - ein hervorgehoben dargestellter Teilring sukzessive, bis er verschwunden ist.

Falls bei einem Lösen der Berührung der berührungsempfindlichen Oberfläche 4 auch nach dem Zeitpunkt t2 das zweite Eingabesignal erzeugt wird, kann das Hinweissymbol 12 so lange angezeigt werden, bis die Berührung gelöst wird und der hervorgehoben dargestellte Teil 11 des Anzeigebereichs 10 dauerhaft angezeigt werden, da in diesem Fall kein Ablauf des zweiten Zeitbereichs ΔT2 visualisiert werden muss. Gemäß einer anderen Ausgestaltung kann nach Ablauf des zweiten Zeitbereichs ΔT2, d.h. nach dem Zeitpunkt t2, wieder die in Figur 3 dargestellte Anzeige wiedergegeben werden. In diesem Fall ist nach dem Zeitpunkt t2 eine Spracheingabe nicht mehr möglich.

Alternativ oder gleichzeitig kann die Mitteilung auch mittels des Lautsprechers 7 akustisch ausgegeben werden. Beispielsweise kann ein akustisches Signal analog zu der vorstehend beschriebenen graphischen Mitteilung ausgegeben werden. Die akustische Kodierung kann dabei beispielsweise über die Veränderung der zeitlichen Struktur des Signals, über die Veränderung der Amplitude und/oder über die Veränderung der Frequenz des akustischen Signals erfolgen. Beispielsweise kann während des zweiten Bereichs ΔT2 ein kurzes akustisches Signal in immer kürzer werdenden Intervallen wiederholt werden. Ebenso ist es möglich, ein leises akustisches Signal analog zur Vergrößerung des hervorgehoben dargestellten Teils 11 des Anzeigebereichs 10 lauter werden oder in der Tonhöhe ansteigen zu lassen.

Schließlich kann alternativ oder zusätzlich die Mitteilung auch über ein haptisches Signal ausgegeben werden. Hierfür wird durch die haptische Ausgabeeinheit 8 z.B. die gesamte Anzeigevorrichtung mit der Anzeigefläche 2 durch mehrere Aktoren in Schwingung versetzt. Beispielsweise können vier Aktoren an den Rändern der Anzeigevorrichtung 1 diese in der Ebene der Anzeigefläche 2 in kurze Schwingbewegungen versetzen, die vom Nutzer, der die berührungsempfindliche Oberfläche berührt, als Vibration und im Fall von sehr kurzen haptischen Signalen als "Klick" im Finger wahrgenommen werden. Für die haptische Ausgabe während des zweiten Zeitbereichs ΔT2 könnte die Amplitude der Vibrationen oder die Frequenz analog zur akustischen Ausgabe variiert werden.

### BEZUGSZEICHENLISTE

1 Anzeigevorrichtung
2 Anzeigefläche
3 Steuervorrichtung
4 Eingabevorrichtung
5 Bedienelement bzw. Schaltfläche
6 Fahrzeugbus
7 Lautsprecher
8 Haptische Ausgabeeinheit
9 Anzeigebereich der Schaltfläche 5
10 Anzeigebereich der Schaltfläche 5
11 Hervorgehobener Teil des Anzeigebereichs 10
12 Hinweissymbol

## Patentansprüche

1. Verfahren zum Bereitstellen einer Benutzerschnittstelle, bei dem
- auf die Betätigung eines Bedienelements (5) für ein erstes Zeitintervall (Δt1) ein erstes Eingabesignal erzeugt wird, wobei das erste Zeitintervall (Δt1) in einem ersten Zeitbereich (ΔT1) liegt, der bei einer initialen Betätigung zu einem ersten Zeitpunkt (t0) beginnt und zu einem zweiten Zeitpunkt (t1) endet,
- auf die Betätigung des Bedienelements (5) für ein zweites Zeitintervall (Δt2) ein zweites Eingabesignal erzeugt wird, wobei das zweite Zeitintervall (Δt2) von der initialen Betätigung zu dem ersten Zeitpunkt (t0) bis zu einem dritten Zeitpunkt dauert, wobei die Betätigung innerhalb eines zweiten Zeitbereichs (ΔT2) beendet wird, wobei sich die beiden Zeitbereiche (ΔT1, ΔT2) nicht überschneiden, und
- nach der initialen Betätigung (t0) des Bedienelements (5) eine Mitteilung dafür ausgegeben wird, dass in Abhängigkeit von der Dauer der Betätigung des Bedienelements (5) unterschiedliche Eingabesignale erzeugt werden, wobei
- zur Betätigung des Bedienelements (5) eine Schaltfläche auf einer Anzeigefläche (2) angezeigt wird,
**dadurch gekennzeichnet,**
**dass** in Folge der initialen Betätigung (t0) die Schaltfläche in einen inneren Anzeigebereich (9) und einen ringförmigen äußeren Anzeigebereich (10) unterteilt wird und
die Mitteilung dadurch erfolgt, dass sich der äußere Anzeigebereich (10) zeitlich so verändert, dass die Länge des ersten und/oder des zweiten Zeitintervalls (Δt1, Δt2) visualisiert wird, wobei
sich ein hervorgehoben dargestellter Teil (11) des äußeren Anzeigebereichs (10) bis zum Ablauf des ersten Zeitbereichs (ΔT1) vergrößert und ab dem Beginn des zweiten Zeitbereichs (ΔT2) wieder verkleinert, wobei
bei der Vergrößerung des hervorgehoben dargestellten Teils (11) zwei Balken so lange wachsend dargestellt werden, bis der Ring des äußeren Anzeigebereichs (10) geschlossen ist.

2. Verfahren nach Anspruch 1,
**dadurch gekennzeichnet,**
**dass** nach der Betätigung des Bedienelements (5) ein akustisches Signal ausgegeben wird und dass die Mitteilung dadurch erfolgt, dass sich das akustische Signal zeitlich so verändert, dass die Dauer des ersten und/oder des zweiten Zeitintervalls (Δt1, Δt2) akustisch mitgeteilt wird.

3. Verfahren nach einem der vorhergehenden Ansprüche,
**dadurch gekennzeichnet,**
**dass** die Mitteilung haptisch ausgegeben wird.

4. Verfahren nach Anspruch 3,
**dadurch gekennzeichnet,**
**dass** das zweite Eingabesignal ein Aktivierungssignal für eine Spracheingabe ist.

5. Bedienvorrichtung mit
- zumindest einem Bedienelement (5),
- einer mit dem Bedienelement (5) gekoppelten Steuervorrichtung (3), mit welcher ein erstes Eingabesignal erzeugbar ist, wenn das Bedienelement (5) für ein erstes Zeitintervall (Δt1) betätigt worden ist, wobei das erste Zeitintervall (Δt1) in einem ersten Zeitbereich (ΔT1) liegt, der bei einer initialen Betätigung zu einem ersten Zeitpunkt (t0) beginnt und zu einem zweiten Zeitpunkt (t1) endet, und ein zweites Eingabesignal erzeugbar ist, wenn das Bedienelement (5) für ein zweites Zeitintervall (Δt2) betätigt worden ist, wobei das zweite Zeitintervall (Δt2) von der initialen Betätigung zu dem ersten Zeitpunkt (t0) bis zu einem dritten Zeitpunkt dauert, wobei die Betätigung innerhalb eines zweiten Zeitbereichs (ΔT2) beendet wird, wobei sich die beiden Zeitbereiche (ΔT1, ΔT2) nicht überschneiden, und
- einer Ausgabevorrichtung (1; 7; 8), mittels welcher nach der initialen Betätigung des Bedienelements (5) eine Mitteilung dafür ausgebbar ist, dass in Abhängigkeit von der Länge der Betätigung des Bedienelements (5) unterschiedliche Eingabesignale erzeugt werden, wobei
- zur Betätigung des Bedienelements (5) eine Schaltfläche auf einer Anzeigefläche (2) anzeigbar ist,
**dadurch gekennzeichnet,**
**dass** in Folge der initialen Betätigung (t0) die Schaltfläche in einen inneren Anzeigebereich (9) und einen ringförmigen äußeren Anzeigebereich (10) unterteilbar ist und
die Mitteilung dadurch erfolgt, dass der äußere Anzeigebereich (10) zeitlich so veränderbar ist, dass die Länge des ersten und/oder des zweiten Zeitintervalls (Δt1, Δt2) visualisiert wird, wobei
sich ein hervorgehoben dargestellter Teil (11) des äußeren Anzeigebereichs (10) bis zum Ablauf des ersten Zeitbereichs (ΔT1) vergrößert und ab dem Beginn des zweiten Zeitbereichs (ΔT2) wieder verkleinert, wobei
bei der Vergrößerung des hervorgehoben dargestellten Teils (11) zwei Balken so lange wachsend darstellbar sind, bis der Ring des äußeren Anzeigebereichs (10) geschlossen ist.

6. Bedienvorrichtung nach Anspruch 5,
**dadurch gekennzeichnet,**
**dass** die auf der Anzeigevorrichtung (1) eine berührungsempfindliche Oberfläche (4) ausgebildet ist und dass das Bedienelement (5) eine von der Anzeigevorrichtung (1) angezeigte Schaltfläche ist.

7. Bedienvorrichtung nach Anspruch 5 oder 6,
**dadurch gekennzeichnet,**
**dass** die Ausgabevorrichtung (1; 7; 8) eine haptische Ausgabeeinheit (8) umfasst.

## Claims

1. Method for providing a user interface, in which
- the operation of an operator control element (5) for a first interval of time (Δt1) is followed by a first input signal being generated, wherein the first interval of time (Δt1) is in a first time range (ΔT1) that begins on initial operation at a first time (t0) and ends at a second time (t1),
- the operation of the operator control element (5) for a second interval of time (Δt2) is followed by a second input signal being generated, wherein the second interval of time (Δt2) lasts from the initial operation at the first time (t0) until a third time, wherein the operation is terminated within a second time range (ΔT2), the two time ranges (ΔT1, ΔT2) not overlapping, and
- the initial operation (t0) of the operator control element (5) is followed by a notification being output that indicates that different input signals are generated on the basis of the duration of the operation of the operator control element (5), wherein
- a button is displayed on a display panel (2) for the purpose of operating the operator control element (5),
**characterized**
**in that** the initial operation (t0) results in the button being divided into an inner display area (9) and an annular outer display area (10), and
the notification is provided by virtue of the outer display area (10) changing over time such that the length of the first and/or second interval of time (Δt1, Δt2) is visualized, wherein
a portion (11) of the outer display area (10) depicted in highlighted fashion is enlarged until the first time range (ΔT1) expires and is reduced again from the beginning of the second time range (ΔT2), wherein
the enlargement of the portion (11) depicted in highlighted fashion results in two bars being depicted in growing fashion until the ring of the outer display area (10) is closed.

2. Method according to Claim 1,
**characterized**
**in that** the operation of the operator control element (5) is followed by an audible signal being output and in that the notification is provided by virtue of the audible signal changing over time such that the duration of the first and/or second interval of time (Δt1, Δt2) is communicated audibly.

3. Method according to either of the preceding claims,
**characterized**
**in that** the notification is output in haptic fashion.

4. Method according to Claim 3,
**characterized**
**in that** the second input signal is an activation signal for a voice input.

5. Operator control apparatus having
- at least one operator control element (5),
- a control apparatus (3), coupled to the operator control element (5), by means of which a first input signal is generable if the operator control element (5) has been operated for a first interval of time (Δt1), wherein the first interval of time (Δt1) is in a first time range (ΔT1) that begins on initial operation at a first time (t0) and ends at a second time (t1), and a second input signal is generable if the operator control element (5) has been operated for a second interval of time (Δt2), wherein the second interval of time (Δt2) lasts from the initial operation at the first time (t0) until a third time, wherein the operation is terminated within a second time range (ΔT2), the two time ranges (ΔT1, ΔT2) not overlapping, and
- an output apparatus (1; 7; 8) by means of which the initial operation of the operator control element (5) is followable by a notification being output that indicates that different input signals are generated on the basis of the length of the operation of the operator control element (5), wherein
- a button is displayable on a display panel (2) for the purpose of operating the operator control element (5),
**characterized**
**in that** the initial operation (t0) results in the button being dividable into an inner display area (9) and an annular outer display area (10), and
the notification is provided by virtue of the outer display area (10) being changeable over time such that the length of the first and/or second interval of time (Δt1, Δt2) is visualized, wherein
a portion (11) of the outer display area (10) depicted in highlighted fashion is enlarged until the first time range (ΔT1) expires and is reduced again from the beginning of the second time range (ΔT2), wherein
the enlargement of the portion (11) depicted in highlighted fashion results in two bars being depictable in growing fashion until the ring of the outer display area (10) is closed.

6. Operator control apparatus according to Claim 5,
**characterized**
**in that** the display apparatus (1) has a touch-sensitive surface (4) produced on it and in that the operator control element (5) is a button displayed by the display apparatus (1).

7. Operator control apparatus according to Claim 5 or 6,
**characterized**
**in that** the output apparatus (1; 7; 8) comprises a haptic output unit (8).

## Revendications

1. Procédé de fourniture d'une interface utilisateur, selon lequel
- un premier signal de saisie est généré sur actionnement d'un élément de commande (5) pendant un premier intervalle de temps (Δt1), le premier intervalle de temps (Δt1) se trouvant dans une première plage de temps (ΔT1) qui commence lors d'un actionnement initial à un premier instant (t0) et se termine à un deuxième instant (t1),
- un deuxième signal de saisie est généré sur actionnement de l'élément de commande (5) pendant un deuxième intervalle de temps (Δt2), le deuxième intervalle de temps (Δt2) s'étendant de l'actionnement initial au premier instant (t0) jusqu'à un troisième instant, l'actionnement se terminant à l'intérieur d'une deuxième plage de temps (ΔT2), les deux plages de temps (ΔT1, ΔT2) ne se chevauchant pas, et
- après l'actionnement initial (t0) de l'élément de commande (5), une communication est délivrée indiquant que des signaux de saisie différents sont générés en fonction de la durée de l'actionnement de l'élément de commande (5),
- en vue de l'actionnement de l'élément de commande (5), un bouton est affiché sur une surface d'affichage (2),
**caractérisé en ce**
**que** suite à l'actionnement initial (t0), le bouton est divisé en une zone d'affichage intérieure (9) et une zone d'affichage extérieure (10) annulaire et
la communication est effectuée de sorte que la zone d'affichage extérieure (10) est modifiée dans le temps de telle sorte que la durée du premier et/ou du deuxième intervalles de temps (Δt1, Δt2) est visualisée,
une partie (11) représentée mise en valeur de la zone d'affichage extérieure (10) s'agrandissant jusqu'à l'écoulement de la première plage de temps (ΔT1) et se réduisant de nouveau à partir du début de la deuxième plage de temps (ΔT2),
lors de l'agrandissement de la partie (11) représentée mise en valeur, deux barres sont représentées croissantes jusqu'à ce que l'anneau de la zone d'affichage extérieure (10) soit fermé.

2. Procédé selon la revendication 1, **caractérisé en ce qu'**après l'actionnement de l'élément de commande (5), un signal sonore est émis et **en ce que** la communication est effectuée de sorte que le signal sonore varie dans le temps de telle manière que la durée du premier et/ou du deuxième intervalles de temps (Δt1, Δt2) est communiquée de manière sonore.

3. Procédé selon l'une des revendications précédentes, **caractérisé en ce que** la communication est émise sous forme haptique.

4. Procédé selon la revendication 3, **caractérisé en ce que** le deuxième signal d'entrée est un signal d'activation pour une entrée vocale.

5. Dispositif de commande comprenant
- au moins un élément de commande (5),
- un dispositif de contrôle (3) couplé à l'élément de commande (5), lequel permet de générer un premier signal de saisie lorsque l'élément de commande (5) a été actionné pendant un premier intervalle de temps (Δt1), le premier intervalle de temps (Δt1) se trouvant dans une première plage de temps (ΔT1) qui commence lors d'un actionnement initial à un premier instant (t0) et se termine à un deuxième instant (t1), et permet de générer un deuxième signal de saisie lorsque l'élément de commande (5) a été actionné pendant un deuxième intervalle de temps (Δt2), le deuxième intervalle de temps (Δt2) s'étendant de l'actionnement initial au premier instant (t0) jusqu'à un troisième instant, l'actionnement se terminant à l'intérieur d'une deuxième plage de temps (ΔT2), les deux plages de temps (ΔT1, ΔT2) ne se chevauchant pas, et
- un dispositif de sortie (1 ; 7 ; 8) au moyen duquel une communication peut être délivrée après l'actionnement initial de l'élément de commande (5), laquelle indique que des signaux de saisie différents sont générées en fonction de la durée de l'actionnement de l'élément de commande (5),
- en vue de l'actionnement de l'élément de commande (5), un bouton peut être affiché sur une surface d'affichage (2),
**caractérisé en ce**
**que** suite à l'actionnement initial (t0), le bouton peut être divisé en une zone d'affichage intérieure (9) et une zone d'affichage extérieure (10) annulaire et
la communication est effectuée de sorte que la zone d'affichage extérieure (10) peut être modifiée dans le temps de telle sorte que la durée du premier et/ou du deuxième intervalles de temps (Δt1, Δt2) est visualisée,
une partie (11) représentée mise en valeur de la zone d'affichage extérieure (10) s'agrandissant jusqu'à l'écoulement de la première plage de temps (ΔT1) et se réduisant de nouveau à partir du début de la deuxième plage de temps (ΔT2),
lors de l'agrandissement de la partie (11) représentée mise en valeur, deux barres sont représentées croissantes jusqu'à ce que l'anneau de la zone d'affichage extérieure (10) soit fermé.

6. Dispositif de commande selon la revendication 5, **caractérisé en ce qu'**une surface tactile (4) est formée sur le dispositif d'affichage (1) et **en ce que** l'élément de commande (5) est un bouton affiché par le dispositif d'affichage (1).

7. Dispositif de commande selon la revendication 5 ou 6, **caractérisé en ce que** le dispositif de sortie (1 ; 7 ; 8) comporte une unité de sortie haptique (8).
